# EUROPEAN PATENT APPLICATION

(11) **EP 0 791 990 A1**
(43) Date of publication of application: **27.08.1997**
(21) Application number: 97102280.1
(22) Date of filing: 13.02.1997
(51) Int. Cl.: H01S 3/085

(54) **Low resistance p-down top emitting ridge VCSEL and method of fabrication**

(30) Priority: 26.02.1996 US 607056
(71) Applicant: MOTOROLA, INC., Schaumburg, IL 60196 (US)
(72) Inventor: Kiely, Philip, Gilbert, Arizona 85233 (US); Claisse, Paul, Gilbert, Arizona 85233 (US)
(74) Representative: Hudson, Peter David

(57) **Abstract**

A high efficiency vertical cavity surface emitting laser (10) including a substrate (12), a first mirror stack (14) having p-type conductivity positioned thereon, a second mirror stack (40) formed of deposited dielectric material, and a cavity (16) positioned therebetween, including an active region (16) positioned between a first cladding layer (18) and a second cladding layer (22). A contact region (24) having n-type conductivity is positioned on the second cladding layer (22), with both forming a mesa structure. An electrical contact (32) engages the contact region (24) and defines a central light emission aperture (34). The device is grown on a p-type substrate.

## Description

### Field of the Invention

This invention relates to vertical cavity surface emitting lasers and more specifically to vertical cavity surface emitting lasers with a mesa structure.

### Background of the Invention

Vertical cavity surface emitting lasers are well known, and are formed in a wide variety of configurations. However, the basis for the laser in virtually all configurations is an active area sandwiched between two mirror stacks. The laser is activated by driving an electrical current through the two mirror stacks and the active area. This is generally accomplished by placing a first electrode across the mirror stack at one end of the laser and a second electrode across the other mirror stack at the other end of the laser. One of the electrodes generally defines a central opening therethrough for the emission of light. Traditionally, and for convenience in manufacturing, VCSEL devices are fabricated with p-type conductivity material forming the top mirror stack and n-type conductivity material forming the bottom mirror stack, generally carried by an n-type conductivity substrate.

For maximum efficiency it is necessary that the major portion of the current be injected into the part of the active region which overlaps with the optical mode. Current outside the lasing area is wasted or produces lasing which is wasted.

To overcome this problem, many devices employ a mesa or ridge, through which the current is injected, having a size closely corresponding to the optical mode. While this reduces wasted current or lasing, it results in an increase in series resistance, reducing efficiency. Further increasing series resistance is the necessary reduction in the area of the top electrode. While the size of the mesa is reduced, the emission window remains the same, causing the reduction in the area of the electrode.

In order to drive the vertical cavity surface emitting laser with a conventional current source, such as a capacitive current source when it is assumed that the device capacitance is already lower than the capacitance of the driver and the package, the series resistance of the device must be reduced. The specific contact resistance of the top mirror stack and the top electrode depends on the doping concentration. However, the doping concentration is constrained by the need to minimize the optical loss due to free carriers. Therefore, optimized doping alone can not achieve a sufficiently low series resistance.

Series resistance can be greatly reduced by increasing the size of the mesa, specifically the top mirror stack, as disclosed in a co-pending U.S. patent application entitled "Low Resistance Top Emitting Ridge VCSEL and Method of Fabrication", serial No. 08/550,148, filed October 30, 1995, and assigned to the same assignee. The current is controlled to enter the active region by oxidized or undercut portions of the top mirror stack adjacent the active region. While effectively reducing series resistance, a further reduction is desirable.

It would be highly advantageous, therefore, to remedy the foregoing and other deficiencies inherent in the prior art.

Accordingly, it is an object of the present invention to provide improvements in vertical cavity surface emitting lasers.

Another object of the invention is to provide a vertical cavity surface emitting laser with a reduced resistance.

And another object of the invention is to provide a vertical cavity surface emitting laser with a p-down structure.

And a further object of the present invention is to increase the speed of operation of a vertical cavity surface emitting laser.

### SUMMARY OF THE INVENTION

Briefly, to achieve the desired objects of the instant invention in accordance with a preferred embodiment thereof, provided is a high efficiency vertical cavity surface emitting laser including a substrate, a first mirror stack having p-type conductivity positioned on the substrate, an active region positioned on the first mirror stack, a second mirror stack formed of deposited dielectric material positioned on the active region, and a contact region having n-type conductivity positioned intermediate the second mirror stack and the active region.

Also provided is a method of fabricating a high efficiency vertical cavity surface emitting laser.

### BRIEF DESCRIPTION OF THE DRAWINGS

The foregoing and further and more specific objects and advantages of the instant invention will become readily apparent to those skilled in the art from the following detailed description of a preferred embodiment thereof taken in conjunction with the drawings, in which:
FIG. 1 is a sectional view of a vertical cavity surface emitting laser constructed in accordance with the teachings of the present invention; and
FIG. 2 is a partial sectional view of the vertical cavity surface emitting laser of FIG. 1.

### DETAILED DESCRIPTION OF THE PREFERRED EMBODIMENTS

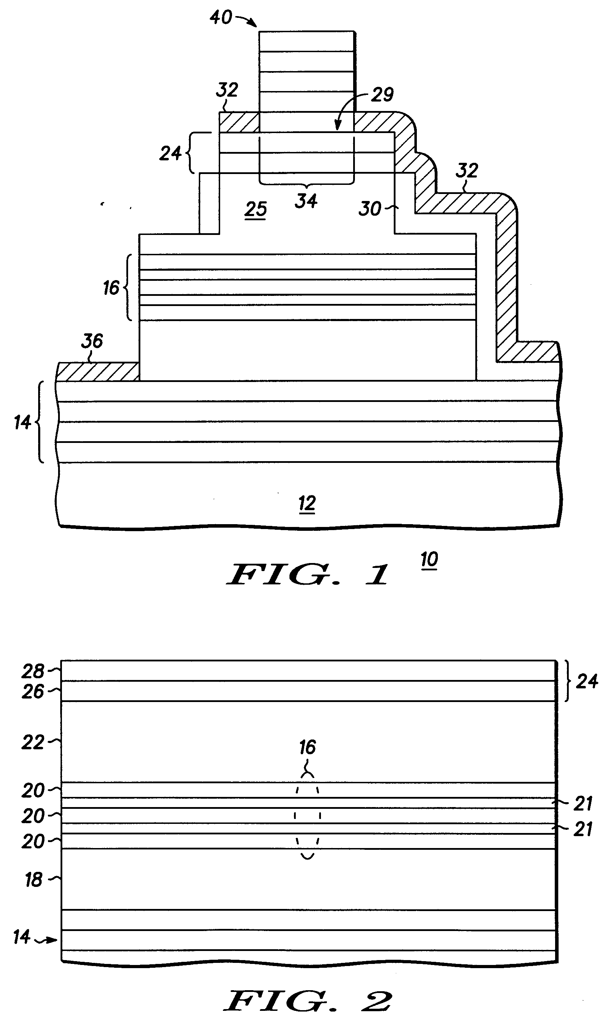

Turning now to the drawings in which like reference characters indicate corresponding elements throughout the several views, attention is first directed to Fig. 1, which illustrates a vertical cavity surface emitting laser (VCSEL) generally designated 10, embodying the present invention. The device of the present invention consists of a plurality of layers, formed on a substrate 12 of a suitable material. Generally, the various layers are formed by epitaxial deposition accomplished by well known techniques in the art such as MBE, MOCVD, CBE, or the like. These techniques enable epitaxial depositions of relatively thin and thick layers of materials such as gallium arsenide, aluminum gallium arsenide, aluminum arsenide, silicon, indium gallium arsenide, etc.

Generally, substrate 12 is gallium arsenide (GaAs) or the like which, as will be understood presently, is compatible with layers subsequently grown thereon. A mirror stack 14 of Bragg mirrors having a p-type conductivity, is grown on an upper surface of substrate 12. This is directly opposite to conventional VCSELs which include a mirror stack having n-type conductivity positioned on the substrate.

It has been found that the holes present in p-type conductivity material move more slowly than the electrons present in the n-type conductivity material. Thus, the inherent resistance of the p-type conductivity material is higher than the resistance of the n-type conductivity. In conventional VCSELs employing a mesa structure, the top mirror stack is formed of p-type conductivity material. The top mirror stack has high resistance because of the reduction in area due to the formation of the mesa-like structure and because it is formed of a material which is already more resistive than if it were formed from n-type conductivity material. Therefore, to reduce series resistance, it has been determined that the portion of the VCSEL having a reduced area, namely the mesa-like structure, should be formed from n-type conductivity material.

Mirror stack 14 is generally formed, for example, by epitaxially growing a plurality of pairs of layers of semiconductor material with alternating indexes of refraction on substrate 12. Each pair of alternating layers are grown to a predetermined thickness (approximately one half wavelength at the operating frequency) and the number of pairs is chosen to provide as much reflectivity of light as possible while limiting the stack to a practical number. In the preferred embodiment, approximately 30-40 pairs of layers are used.

An active region 16 generally including one or more quantum wells separated by barrier layers is grown on mirror stack 14 with cladding layers on either side thereof. The quantum wells, barrier layers and cladding layers are grown epitaxially. The quantum wells produce photons (light) in accordance with a well known phenomenon when properly energized by electrical current applied thereacross. In general, the greater the current applied to active region 16 the greater the number of photons generated.

With additional reference to FIG. 2, in the preferred embodiment, a layer is deposited over mirror stack 14 to form a cladding layer 18 of p-type conductivity in VCSEL 10. Cladding layer 18 is either lightly doped with an impurity to produce the p-type conductivity or is undoped. Five layers of undoped material cooperate to provide three quantum well layers 20 separated by two barrier layers 21. It should be understood that fewer or more layers may be employed to provide the desired active region. A second cladding layer 22 is deposited on the upper surface of active region 16 and is either lightly doped with an impurity to produce a n-type conductivity or is undoped. Layers 18, 20, 21 and 22 form what is commonly referred to as the cavity of VCSEL 10 and is the light generating portion of VCSEL 10. In the present embodiment of VCSEL 10 the cavity is made very long, employing relatively thick, lightly doped cladding layers for purposes which will be discussed presently. The formation of mirror stack 14 and active region 16 is well known in the art and will not be elaborated upon further in this disclosure.

A contact region 24 is deposited onto the top surface of second cladding layer 22. Contact region 24 is phase matched to the cavity, and includes a first layer 26 positioned on second cladding 22 and a second layer 28 positioned on first layer 26. Each of layers 26 and 28 is preferably less than or equal to 100 angstroms with first layer 26 formed of AlGaAs and second layer 28 formed of GaAs. Contact region 24 is heavily doped with an impurity to produce n-type conductivity and to insure a good contact between contact region 24 and an electrical contact which will be described more fully later in the description.

Cladding layer 22 and contact region 24 are formed into a mesa 25 on active region 16 by conventional etching techniques. A long cavity is provided to allow for the formation of mesa 25, also referred to as ridge patterning, without etching through active region 16. Etching of active region 16 will greatly reduce the reliability of the VCSEL, and is therefore to be avoided. It has been determined that a mesa with a step (height) in the range of approximately 2,000 - 3,000 angstroms will be required to provide good optical confinement. To achieve this step without etching into active region 16, a 2 -3 wavelength cavity is preferred, with first cladding layer 18 having a 1 wavelength thickness and second cladding layer 22 having a 2 wavelength thickness. It is only second cladding layer 22 and contact region 24 which are etched.

As described previously, to reduce series resistance, first mirror stack 14 is formed with p-type conductivity material, while mesa 25 is formed with n-type conductivity material, namely contact region 24 and second cladding layer 22. This reduces resistance because n-type conductivity material has a lower resistance than does p-type conductivity material. Thus, in comparison with the conventional p-up configuration, this p-down configuration provides the higher resistance p-type conductivity material of first mirror stack 14 with a large area. This area has a diametric size which is substantially larger (greater than or approximately twice) the diametric size of mesa 25. The large area permits spreading of the current flow, thus reducing resistance. The n-type conductivity material of contact region 24 and second cladding layer 22 is inherently less resistive, and thus the reduction of the area of contact region 24 and second cladding layer 22, formed of n-type conductivity material, to form mesa 25 will be less significant than if it were formed of p-type conductivity material.

After formation, mesa 25 has an upper surface 29 corresponding to the top surface of contact region 24 and substantially vertical sides. A dielectric layer 30 is deposited on the vertical sides of mesa 25 up to contact region 24. Dielectric layer 30 may be substantially any of the well known materials such as silicon nitride (SiNx), and prevents electrical current from entering VCSEL 10 from anywhere except contact region 24 and causing a short.

A first electrical contact 32 is deposited on the upper surface of contact region 24 and on dielectric layer 30 over the vertical sides. First electrical contact 32 forms an ohmic contact with contact region 24. In this specific embodiment first electrical contact layer 32 is formed of a n-type metal. First electrical contact layer 32 is deposited over the entire upper surface and sides of VCSEL 10 (on the outside of dielectric layer 30) except for a light emitting aperture 34 centrally located on upper surface 29. The diametric size of aperture 34 is preferably in the range of 5 - 50 microns.

A Second electrical contact 36 is deposited adjacent the device, on first mirror stack 14. Second electrical contact 36 is a p-type metal, and is the opposing contact to first electrical contact 32. Current passed between first electrical contact 32 and second electrical contact 36 generates photons within active region 16 as described previously. It will be understood that second electrical contact 36 may be positioned in different locations as desired, such as between substrate 12 and mirror stack 14 or on the lower surface of substrate 12. In the later instance, substrate 12 would be heavily doped with an impurity to produce a p-type conductivity. It will further be understood that electrical contact 36 may be a highly doped semiconductor material instead of metal.

While n-type conductivity material has less resistance than does p-type conductivity material, the vertical resistance of n-type mirror stack may be high due to poor ionization of donors in the layers having high aluminum content. Aluminum is commonly used in mirror stacks to provide the different indexes of refraction. To avoid this problem and further reduce resistance, a second mirror stack 40 is subsequently formed by depositing a plurality of layers of a dielectric material onto the top surface of mesa 25. Dielectric mirror stack 40 is deposited after formation of mesa 25 and the deposition of first electrical contact 32.

Thus, current injection is controlled, with current injected into active region 32 in an optical mode determined by the diametric size of mesa 25 formed of n-type conductivity material, and series resistance is greatly reduced due to the p-down structure which presents the bottom mirror stack as a p-type conductivity material having a large area and the use of a dielectric top mirror stack.

Various changes and modifications to the embodiments herein chosen for purposes of illustration will readily occur to those skilled in the art. To the extent that such modifications and variations do not depart from the spirit of the invention, they are intended to be included within the scope thereof which is assessed only by a fair interpretation of the following claims.

Having fully described the invention in such clear and concise terms as to enable those skilled in the art to understand and practice the same, the invention claimed is:

## Claims

1. A high efficiency vertical cavity surface emitting laser (10) comprising:
a substrate (12);
a first mirror stack (14) having p-type conductivity positioned on the substrate (12);
an active region (16, 18, 22) positioned on the first mirror stack (14);
a second mirror stack (40) formed of deposited dielectric material positioned on the active region (16, 18, 22); and
a contact region (24) having n-type conductivity positioned intermediate the second mirror stack (40) and the active region (16, 18, 22).

2. A high efficiency vertical cavity surface emitting laser as claimed in claim 1 further characterized by a first cladding layer (18) positioned intermediate the first mirror stack (14) and the active region (16), and a second cladding layer (22) positioned intermediate the active region (16) and the contact region (24), the first cladding layer (18), active region (16) and second cladding layer (22) forming a cavity.

3. A high efficiency vertical cavity surface emitting laser as claimed in claim 2 wherein the cavity is further characterized by being at least 2 wavelengths thick.

4. A high efficiency vertical cavity surface emitting laser as claimed in claim 3 wherein the second cladding layer (22) and the contact region (16) are further characterized by forming a mesa structure.

5. A high efficiency vertical cavity surface emitting laser as claimed in claim 4 wherein the mesa structure is further characterized by forming a step in the range of approximately 2,000 - 3,000 angstroms.

6. A high efficiency vertical cavity surface emitting laser as claimed in claim 4 wherein the first mirror stack (14) is further characterized by having a diametric size which is at least twice as large as the diametric size of the mesa structure.

7. A high efficiency vertical cavity surface emitting laser as claimed in claim 4 further characterized by an electrical contact (32) engaging the contact region (24), the electrical contact (32) defining a central light emission aperture (34) through which light is emitted, the aperture (34) having a diameter in the range of approximately 5-50 microns.

8. A high efficiency vertical cavity surface emitting laser as claimed in claim 4 wherein the contact region (24) is further characterized by being phase matched to the cavity.

9. A high efficiency vertical cavity surface emitting laser as claimed in claim 4 further characterized by a second electrical contact (36) coupled to the first mirror stack (14).

10. A method of fabricating a high efficiency vertical cavity surface emitting laser characterized by the steps of:
providing a substrate (12);
forming a first mirror stack (14) having p-type conductivity on the substrate (12);
forming a cavity (16, 18, 22) on the first mirror stack (14);
forming a contact region (24) having n-type conductivity on the cavity (16, 18, 22) ; and
forming a second mirror stack (40) of deposited dielectric material on the contact region (24).
